# EUROPEAN PATENT SPECIFICATION

(11) **EP 1 404 023 B1**
(45) Date of publication and mention of the grant of the patent: **27.01.2010**
(21) Application number: 03021563.6
(22) Date of filing: 24.09.2003
(51) Int. Cl.: H03M 13/27

(54) **Channel decoder for a european DAB receiver and channel decoding method thereof**
Kanaldekodierer für einen europäischen DAB Empfänger und zugehöriges Kanaldekodierverfahren
Décodeur de canal pour un récepteur de DAB européen et procédé de décodage de canal correspondant

(30) Priority: 24.09.2002 KR 2002057868
(43) Date of publication of application: 31.03.2004
(60) Divisional application: 06017376.2
(73) Proprietor: SAMSUNG ELECTRONICS CO., LTD., Suwon-City, Kyungki-do (KR)
(72) Inventor: Lee, Jeong-taek, Seodaemoon-gu Seoul (KR)
(74) Representative: Grünecker, Kinkeldey, Stockmair & Schwanhäusser Anwaltssozietät

(56) References cited:
- EP-A- 0 865 176
- EP-A- 0 874 485
- EP-A- 0 945 989
- EP-A- 0 961 432
- EP-A- 0 971 483
- EP-A- 1 111 867
- US-A- 5 912 898
- US-A- 5 943 371
- US-A- 6 163 571
- US-A1- 2002 046 329
- SHIEH M-D ET AL: "DESIGN AND IMPLEMENTATION OF A DAB CHANNEL DECODER" IEEE TRANSACTIONS ON CONSUMER ELECTRONICS, IEEE INC. NEW YORK, US, vol. 45, no. 3, August 1999 (1999-08), pages 553-562, XP000926966 ISSN: 0098-3063

## Description

The present invention relates to a European digital audio broadcasting (DAB) receiver, and more particularly, to a channel decoding apparatus.

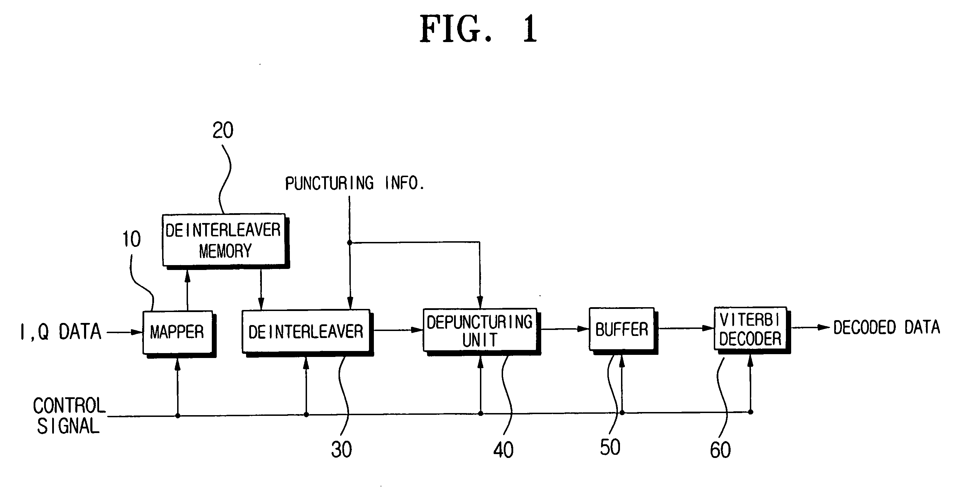

FIG. 1 is a schematic block diagram of a channel decoding apparatus for use in a general European digital audio broadcasting (DAB) receiver.

The channel decoding apparatus of the DAB receiver includes a mapper 10, a deinterleaver memory 20, a deinterleaver 30, a depuncturing unit 40, a buffer 50 and a viterbi decoder 60.

The mapper 10 stores input of I and Q data to the deinterleaver memory 20.

The deinterleaver memory 20 usually has a capacity of about 4Mbit corresponding to 16 common interleaved frames (CIF) in the viterbi decoding, and stores data inputted from the mapper 10.

The deinterleaver 30 reads data one by one in the interleaving order at transmitting ends of the 16 respective CIFs (soft-decision type) based on the puncturing information. The puncturing information usually contains 4 types of puncturing vectors such as 1111, 1110, 1100, 1000 for the European DAB transmitter/receiver.

The depuncturing unit 40 performs depuncturing based on the puncturing vectors, i.e., inserts predetermined data in the place of data which are punctured at the transmitting end. More specifically, numerous data are generated from a convolution encoding on a single data at the transmitting end, and in order to enhance transmission rate of the convolution-encoded data, some data are punctured before the transmission. Based on the puncturing vectors, the depuncturing unit 40 inserts proper data, for example 7, in the punctured data as received.

The buffer 50 stores the deinterleaved and depunctured data based on the puncturing vectors and then outputs 4-bit in soft-decision.

Table 1 below shows respective data D after convolution encoding, puncturing and depuncturing.

**[Table 1]**

| Data | D | | | |
|---|---|---|---|---|
| Convolution-encoded data | 4D₀, 4D₁, 4D₂, 4D₃, | | | |
| Puncturing vector | 1 1 1 1 | 1 1 1 0 | 1 1 0 0 | 1 0 0 0 |
| Punctured data | 4D₀ 4D₁ 4D₂ 4D₃ | 4D₀ 4D₁ 4D₂ | 4D₀ 4D₁ | 4D₀ |
| Depunctured data | 4D₀4D₁4D₂4D₃ | 4D₀4D₁4D₂7 | 4D₀4D₁77 | 4D₀777 |

The viterbi decoder 60 processes viterbi decoding with respect to the depunctured data of the buffer 50 in the unit of 4-bit soft-decision data, namely, 4D₀ 4D₁ 4D₂ 4D₃, 4D₀ 4D₁ 4D₂ 7, 4D₀ 4D₁ 7 7, 4D₀ 7 7 7 (4D = 4bit data).

However, the channel decoding apparatus of the conventional European DAB receiver has the following drawbacks.

The first problem is related to the address structure of the deinterleaver memory 20, the example of which is shown below.

### [Example 1]

| | |
|---|---|
| CIF address (4bit) | DATA address (15 bit) |

As shown in the Example 1, 4-bit CIF address is set as an upper address, while 15-bit data address of each CIF is set as a lower address. Accordingly, the deinterleaver memory 20 stores data in an absolute address which is the combination of the 4-bit CIF address and 15-bit data address. Since the CIF address and the data address are operated independently from each other, deinterleaving becomes easier. However, there is a drawback that the CIF always has an empty space which is not filled with the data. This means empty addresses in the respective CIFs and subsequent wastage of memory space.

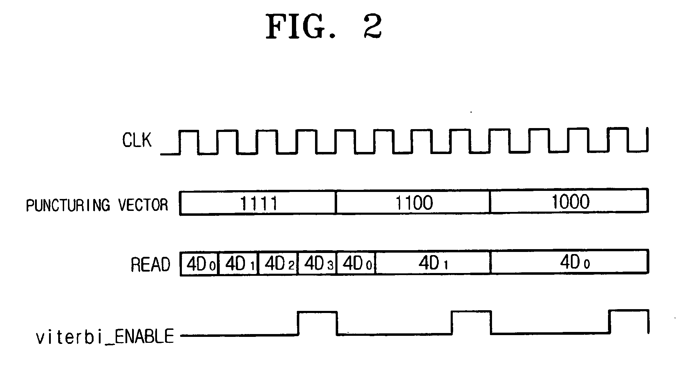

The second problem of the channel decoding apparatus of the conventional European DAB receiver is the decoding time. FIG. 2 is a timing view illustrating the operation of the channel decoding apparatus of FIG. 1.

As shown in the timing view of FIG. 2, with the 'READ' signal, data stored in the deinterleaver memory 20 are read at irregular timing based on the puncturing vectors. For example, with the punctured vector '1111', data 4D₀, 4D₁, 4D₂, 4D₃ are read one by one in correspondence with the clock signal CLK. With the puncturing vector '1000', only one data, i.e., 4D₀ is read during the 4 clock signals. Meanwhile, with the reception of signal Viterbi_ENABLE to the viterbi decoder 60, data are decoded with regular periodicity. The Viterbi_ENABLE signal is applied with 4 clock periodicity. While there is no waste of clock signals with the puncturing vector '1111', 2 clock signals are wasted with the puncturing vector '1100' and 3 clock signals are wasted with the puncturing vector '1000'. As a result, decoding time and power consumption increases with respect to the entire frames of the DAB data.

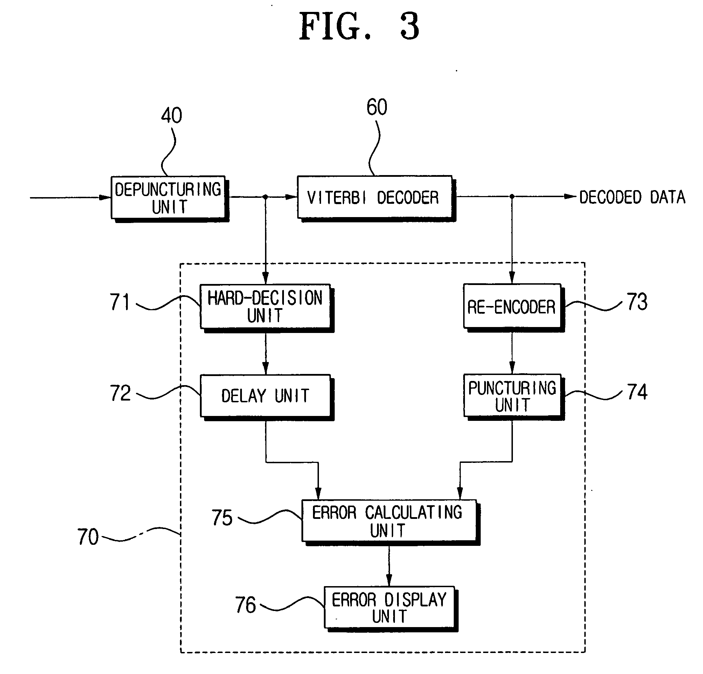

Thirdly, there is a problem in a performance measuring equipment 70 of the viterbi decoder 60 which is schematically shown in the block diagram of FIG. 3. The performance of the viterbi decoder 60 is determined by measuring error rate, i.e., by estimating the data before the viterbi decoding using output signals from the viterbi decoder 60 and then comparing the estimated data with the input data to the viterbi decoder 60.

As shown in FIG. 3, the performance measuring equipment 70 of the viterbi decoder 60 includes a hard-decision unit 71, a delay unit 72, a re-encoder 73, a puncturing unit 74, an error calculating unit 75 and an error display unit 76.

The hard-decision unit 71 converts the soft-decision data inputted to the viterbi decoder 60 into hard-decision data. The hard-decision data are delayed at the delay unit 72 by the duration as much as the data are decoded and outputted from viterbi decoder 60. The data are outputted after the delay. When the decoded data are outputted from the viterbi decoder 60, output data are convolution-encoded at the re-encoder 73 and punctured at the puncturing unit 74 according to the puncturing information. The punctured data from the puncturing unit 74 and the delayed data from the delay unit 72 are inputted to the error calculating unit 75 to be compared with the data which are not punctured, and as a result, an error rate is calculated. The calculated error rate is displayed externally through the error display unit 75.

In the conventional performance measuring apparatus 70, the puncturing unit 74, which is the same as the depuncturing unit 40 of the channel decoding apparatus, is additionally required to generate puncturing vectors for the puncturing of the convolution-encoded data. Accordingly, system becomes complicated and unnecessary power consumption grows.

US 5,943,371 discloses a memory efficient time de-interleaver, de-puncture, and Viterbi decoder circuitry. A control interface circuit feeds decoding information to the time de-interleave component, de-puncture component, Viterbi decoder component and a program manager component via a signal path. The rate of the time de-interleaved process performed by the time de-interleaved block is set by the decoding rate of the Viterbi decoder block. In general, the time de-interleaved block must pull metric data from external memory via a signal path at a rate that is fast enough to keep up with the Viterbi decoder rate. The de-punctured data are passed to the Viterbi decoder block via another signal path.

Shieh M-D et al: "Design and Implementation of a DAB channel decoder, IEEE Transactions on Consumer Electronics, IEEE Inc. New York, US, vol. 45, no. 3, August 1999, pages 553-562 discloses a design and implementation of a DAB channel decoder and their corresponding VLSI implementations.

US 2002/046329 A1 discloses an apparatus for controlling time de-interleaver memory for digital audio broadcasting that reduces a required minimum memory capacity of a DAB receiver.

EP-A-0 971 483 discloses a deinterleaver device that deinterleaves an input transmission frame and outputs the deinterleaved frame by performing interframe interleaving for an original frame.

It is therefore the object of the present invention to provide channel decoding apparatuses of a European digital audio broadcasting receiver and corresponding channel decoding methods capable of improving the address structure of a deinterleaver memory.

This object is solved by the subject matter of the independent claims.

Preferred embodiments are defined by the dependent claims.

Accordingly, it is a first aspect of the present invention to improve address structure of a deinterleaver memory so as to increase efficiency thereof.

It is a second aspect of the present invention to reduce channel decoding time of entire system so as to reduce power consumption.

It is a third aspect of the present invention to realize a performance measuring apparatus for a viterbi decoder in simple structure so as to reduce power consumption and complexity of the system.

In order to achieve the above aspects and/or features of the present invention, there is provided a European digital audio broadcasting receiver which will be described with reference to several embodiments of the present invention.

According to a first preferred embodiment, a channel decoding apparatus of a European digital audio broadcasting (DAB) receiver includes a deinterleaver memory having a first address that designates one data group among plural data groups, and a second address that designates one data among data included in the respective data groups, the deinterleaver memory with the address structure that has the second address as an upper address and the first address as a lower address, a mapper for mapping and storing an input data in the deinterleaver memory according to the address structure of the deinterleaver memory, a deinterleaver for, at a regular timing, deinterleaving the data stored in the deinterleaver memory and thereby generating a deinterleaved data, a depuncturing unit for inserting a predetermined value in the place of a punctured data based on a puncturing information, thereby generating a depuncturing data, and a viterbi decoder for decoding a predetermined unit of coded data into original form before the coding, the predetermined unit of code data being comprised of the deinterleaved data and the depunctured data.

The plural data groups are common interleaved frames, the one data group among the plural data groups has a 4-bit address, one data of the data has a 15-bit address, and the address structure of the deinterleaver memory has the 15-bit address as the upper address and 4-bit address as the lower address.

Also according to the first preferred embodiment, a channel decoding method of a European digital audio broadcasting (DAB) receiver includes the steps of storing data according to an address structure that has a first address designating one data group among plural data groups, and a second address designating one data among data included in the respective data groups, the address structure having the second address as an upper address and the first address as a lower address, deinterleaving at a regular timing the data which are stored according to the address structure and thereby generating a deinterleaved data, inserting a predetermined value in the place of a punctured data based on a puncturing information, thereby generating a depuncturing data, and decoding a predetermined unit of coded data into original form before the coding, the predetermined unit of code data being comprised of the deinterleaved data and the depunctured data.

According to a second example, a channel decoding apparatus of a European digital audio broadcasting (DAB) receiver includes a mapper mapping and storing an input data in a deinterleaver memory, a deinterleaver for, at a regular timing, deinterleaving the data stored in the deinterleaver memory and thereby generating a deinterleaving data, a depuncturing unit for inserting a predetermined value in the place of a punctured data based on a puncturing information, thereby generating a depuncturing data, and a viterbi decoder for decoding a predetermined unit of coded data into original form before the coding, the predetermined unit of code data being comprised of the deinterleaved data and the depunctured data. The depuncturing unit controls the decoding of the viterbi decoder based on the puncturing information.

The depuncturing unit applies an ENABLE signal to the viterbi decoder to operate the viterbi decoder, at the time when the deinterleaved data is inputted to the viterbi decoder. The depunctured data is inputted to the viterbi decoder at the time when the ENABLE signal is applied to the viterbi decoder.

Also according to the second example, a channel decoding method of a European digital audio broadcasting (DAB) receiver includes the steps of mapping and storing an input data, deinterleaving the stored data stored at a regular timing according to a predetermined rule, thereby generating a deinterleaving data, inserting a predetermined value in the place of a punctured data based on a puncturing information, thereby generating a depuncturing data, and decoding a predetermined unit of coded data into original form before the coding, the predetermined unit of coded data being comprised of the deinterleaved data and the depunctured data and inputted from a viterbi decoder.

The depuncturing step further includes the step of applying an ENABLE signal to the viterbi decoder to operate the viterbi decoder. The ENABLE signal is applied to the viterbi decoder based on the puncturing information at the time when the deinterleaved data is inputted to the viterbi decoder. The depuncturing step inputs the depunctured data to the viterbi decoder at the time when the ENABLE signal is applied to the viterbi decoder.

According to a third example, a performance measuring apparatus provided to a channel decoding apparatus of a European digital audio broadcasting (DAB) receiver includes a puncturing information inserting unit for inserting an information data as a puncturing information in the signal inputted from a viterbi decoder, a re-encoder for convolution-encoding the signal outputted from the viterbi decoder, and an error calculating unit for estimating the puncturing information by using the information data, and calculating a decoding error rate by comparing the data from the viterbi decoder with the convolution-encoded data.

Further provided is a hard decision unit for converting the data, which is inserted with the information data and then outputted from the puncturing information inserting unit, into a hard-decision data. The hard-decision unit estimates the puncturing information based on the information data and providing the error calculating unit with the estimated puncturing information.

Meanwhile, a performance measuring method includes the steps of inserting an information data as a puncturing information in a data inputted from a viterbi decoder, and calculating an error rate by comparing an input data to the viterbi decoder and an output data from the viterbi decoder based on the puncturing information that is estimated through the information data.

Further provided is the step of converting the data inserted with the information data into a hard-decision data. The hard-decision converting step estimates the puncturing information based on the information data, and the error calculating step calculates the error rate by using the estimated puncturing information.

The deinterleaver memory of improved address structure enables efficient use of memory, and controlling of the depuncturing unit on the viterbi decoder shortens the decoding time. Furthermore, because a circuit of the performance measuring apparatus of the viterbi decoder can be constructed in simple structure, the entire channel decoding system can subsequently have simple structure.

### BRIEF DESCRIPTION OF THE DRAWINGS

The above object and other features of the present invention will become more apparent by describing in detail a preferred embodiment thereof with reference to the attached drawings, in which:
FIG. 1 is a schematic block diagram of a channel decoding apparatus of a conventional digital audio broadcasting (DAB) receiver;
FIG. 2 is a timing view illustrating the operation of FIG. 1;
FIG. 3 is a schematic block diagram of a performance measuring apparatus of the viterbi decoder of FIG. 1;
FIG. 4 is a schematic block diagram of a channel decoding apparatus of a European digital audio broadcasting (DAB) receiver according to the present invention;
FIG. 5 is a view illustrating a memory address structure according to a first preferred embodiment of the present invention;
FIG. 6 is a flowchart illustrating a channel decoding method according to the first preferred embodiment of the present invention;
FIG. 7 is a timing view illustrating the operation according to a second example useful for understanding the present invention;
FIG. 8 is a flowchart illustrating a channel decoding method according to the second example;
FIG. 9 is a schematic block diagram of a performance measuring apparatus of a channel decoding apparatus according to a third example useful for understanding the present invention; and
FIG. 10 is a flowchart illustrating a performance measuring method of the channel decoding apparatus according to the third example.

### DETAILED DESCRIPTION OF THE PREFERRED EMBODIMENT

Hereinafter, the present invention will be described in detail with reference to the accompanying drawings.

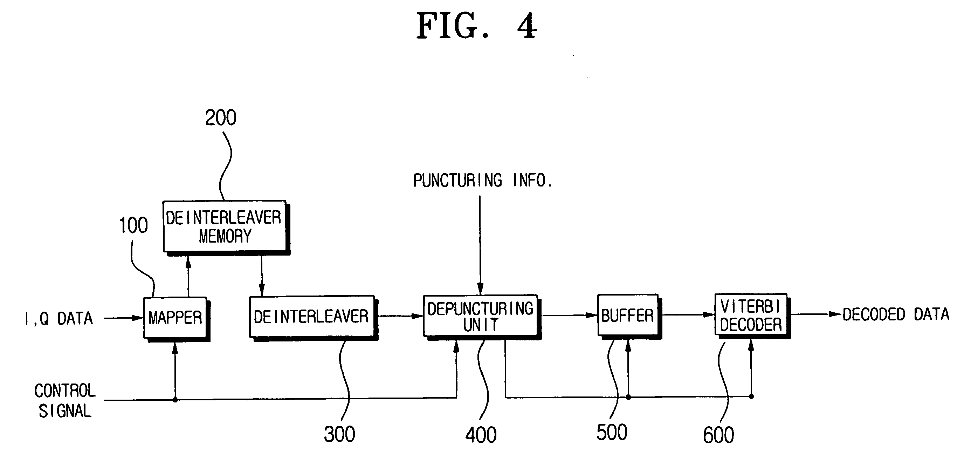

FIG. 4 is a schematic block diagram of a channel decoding apparatus for use in a digital audio broadcasting (DAB) receiver according to the present invention. Referring to FIG. 4, the first through third preferred embodiments will be described in greater detail.

The channel decoding apparatus includes a mapper 100, a deinterleaver memory 200, a deinterleaver 300, a depuncturing unit 400, a buffer 500 and a viterbi decoder 600.

The mapper 100 maps and stores input of I and Q data to the deinterleaver memory 200.

The deinterleaver memory 200 has a capacity about 4Mbit that corresponds to the 16 common interleaved frames (CIFs), and also has an absolute address which is the combination of 4-bit CIF address and 15-bit data address.

The deinterleaver 300 processes deinterleaving, i.e., reads the data of the 16 CIFs stored in the deinterleaver memory 200 one by one according to the interleaving order at the transmitting end. Instead of reading the data based on the puncturing information, the deinterleaver 300 reads data at a regular timing based on the puncturing information.

Based on the puncturing information, the depuncturing unit 400 inserts predetermined data in the place of the punctured data which are punctured at the transmitting end. For example, with the puncturing data of '1000', the depuncturing unit 400 inserts '7', which is a median soft-decision data, in the place of three punctured data. Then the depuncturing unit 400 outputs the depunctured data.

The buffer 500 stores 4-bit data in soft-decision i.e., stores 16-bit deinterleaved and depunctured data, and outputs the data to the soft-decision viterbi decoder 600.

The viterbi decoder 600 processes viterbi decoding with respect to the 16-bit data inputted from the buffer 500. Operation of the viterbi decoder 600 under the control of the depuncturing unit 400 will be described later with respect to the second preferred embodiment.

Hereinbelow, the preferred embodiment of the present invention will be described in greater detail with reference to the accompanying drawings.

According to the first preferred embodiment of the present invention provided to accomplish the first object, the address structure of the deinterleaver memory 200 is improved and storage efficiency of the memory is subsequently enhanced.

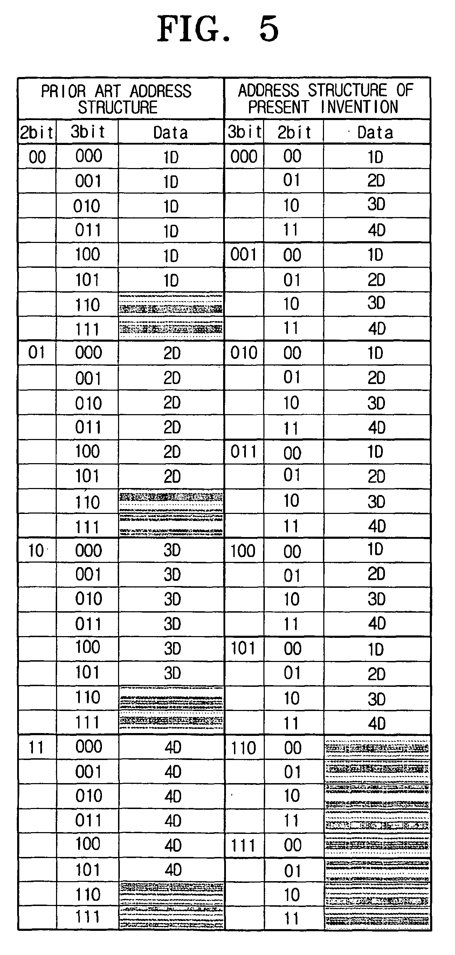

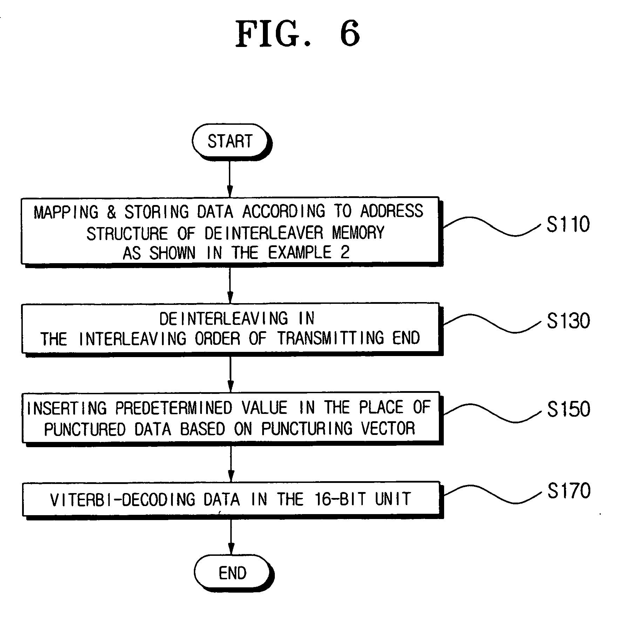

The example 2 and the table of FIG. 5 will be referred to, while describing the improved address structure according to the first preferred embodiment. FIG. 6 is for explaining a channel decoding method according to the improved address structure.

The improved address structure of the deinterleaver memory 20 according to the first preferred embodiment of the present invention is as follows:

### [Example 2]

| | |
|---|---|
| DATA address (15 bit) | CIF address (4 bit) |

The deinterleaver memory 200 has the 15-bit address data of the CIF as an upper address, and 4-bit address for the CIF as a lower address.

Described below with reference to the table of FIG. 5 is the mapping of the data stored according to the above memory address structure as compared to that of the data stored according to the conventional memory address structure.

For the sake of convenience in describing the embodiment, the 4-bit CIF address is assumed to be 2-bit CIF address, and 15-bit data address is assumed to be 3-bit data address. Also, the description with reference to FIG. 5 will be made mainly in terms of the empty address spaces of the conventional address structure and the address structure of the first preferred embodiment.

As shown in FIG. 5, in the conventional memory which has an address structure having CIF address as upper address and data address as lower address (Example 1), data 1D to 4D are sequentially stored in the respective CIFs, leaving empty addresses 100 and 111 (indicated as dark cells) in the respective CIFs according to size of the data being stored.

Compared to the conventional memory, in the memory of the first preferred embodiment of an address structure that has data address as upper address and CIF address as lower address (Example 2), data are mapped with respect to the address structure in a linear manner, thus leaving empty address spaces collectively at the lower portion of the entire memory address structure. The empty address spaces can be additionally used for storing other data, and as a result, storage efficiency of the memory improves.

The mapper 100 stores the input data according to the address structure of the deinterleaver memory 200 as shown in the example 2 (step S110). Next, the deinterleaver 300 processes deinterleaving, i.e., reads the stored data in the address structure of the deinterleaver memory 200 as shown in the example 2 one by one (step S130). Based on the puncturing information, i.e., based on the puncturing vectors, the depuncturing unit 400 inserts predetermined data in the place of data that are punctured at the transmitting end (step S150). The soft-decision viterbi decoder 600 processes viterbi decoding with respect to the data in the 16-bit data unit (step S170).

The deinterleaver memory 200, which has the address structure such as the one shown in the example 2 according to the present invention, can additionally store up to 12288-bit CIF data in the empty memory spaces, if considering the general 4Mbit memory capacity and OFDM symbol data. As a result, memory capacity is fully utilized.

Next, according to the second preferred embodiment of the present invention which is provided to achieve the second object, the decoding operation of the viterbi decoder 600 is appropriately controlled so that overall decoding time can be shortened.

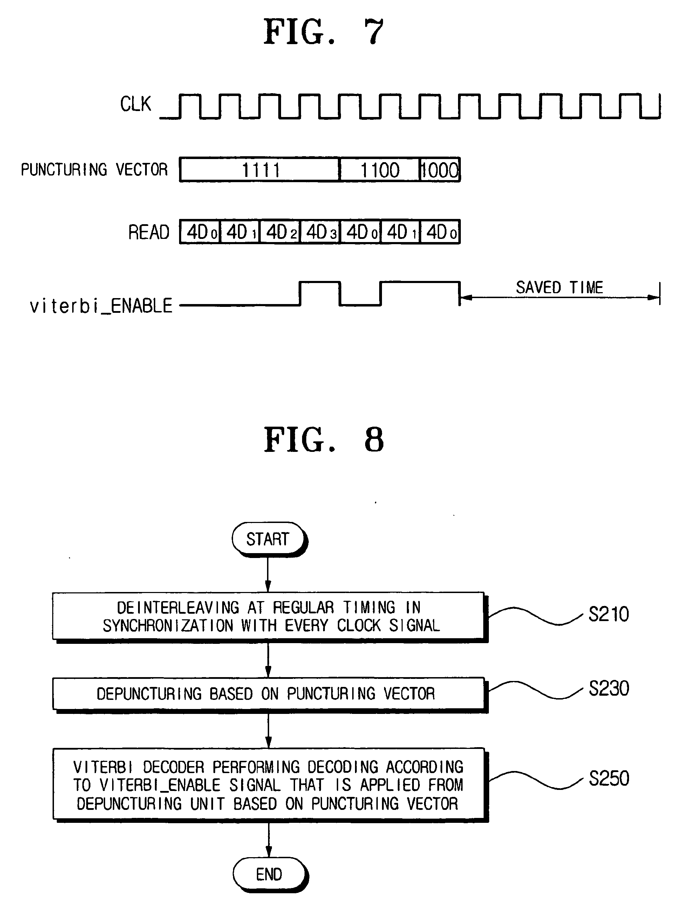

FIG. 7 is a timing view for illustrating the second exampleand FIG. 8 is a flowchart for illustrating the channel decoding method according to the second example. The second example will be described in greater detail below with reference to FIGS. 7 and 8.

The deinterleaver 300, with the reception of READ signal in synchronization with every clock signal CLK, processes deinterleaving, i.e., reads the stored data (4D₀ 4D₁ 4D₂ 4D₃, 4D₀ 4D₁ 4D₀...) from the deinterleaver memory 200 at a regular timing (step S210).

Next, based on the puncturing information inputted from the depuncturing unit 400, predetermined data are inserted in the deinterleaved data which are inputted at regular timing, i.e., the predetermined data are inserted in the place of the punctured data of the incoming deinterleaved data (step S230).

The data after the deinterleaving and depuncturing are inputted to the soft-decision viterbi decoder 600 in the 16-bit data unit.

The viterbi decoder 600 receives Viterbi_ENABLE signal from the depuncturing unit 400 based on the puncturing vectors, and processes decoding accordingly (step S250).

For example, with the puncturing vector '1111', the depuncturing unit 400 applies Viterbi_ENABLE to the viterbi decoder 600 when the last data i.e., 4D₃ among deinterleaved data 4D₀ 4D₁ 4D₂ 4D₃ is inputted to the viterbi decoder 600. With the puncturing vector '1100', the depuncturing unit 400 applies Viterbi_ENABLE to the viterbi decoder 600 when the last data i.e., 4D₁ among deinterleaved data 4D₀ 4D₁ is inputted to the viterbi decoder 600. The depunctured data are concurrently inputted as the Viterbi_ENABLE is applied to the viterbi decoder 600.

Because the Viterbi_ENABLE is applied from the depuncturing unit 400 to the viterbi decoder 600 based on the puncturing vector, decoding time can be shortened. For example, in the case where there are much of the punctured data such as in the case with the puncturing vector '1000', decoding time becomes shorter as much as 3 clock CLK signals as compared to the conventional cases.

Considering the entire DAB frames into account, decoding time of the channel decoding apparatus is reduced substantially and power consumption is subsequently reduced.

Next, according to the third preferred embodiment provided to achieve the third object, the performance measuring apparatus 700 for determining performance of the viterbi decoder 600 is designed with simple circuit construction and thus consumes less power.

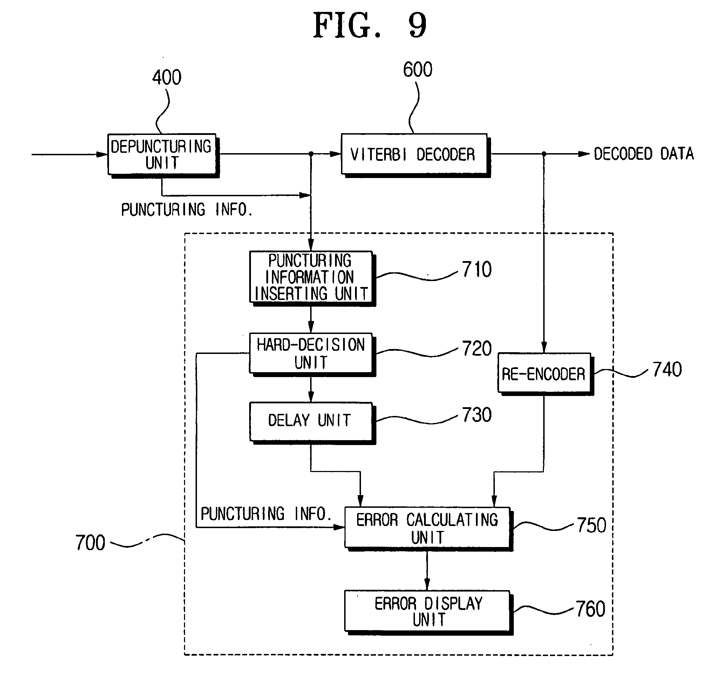

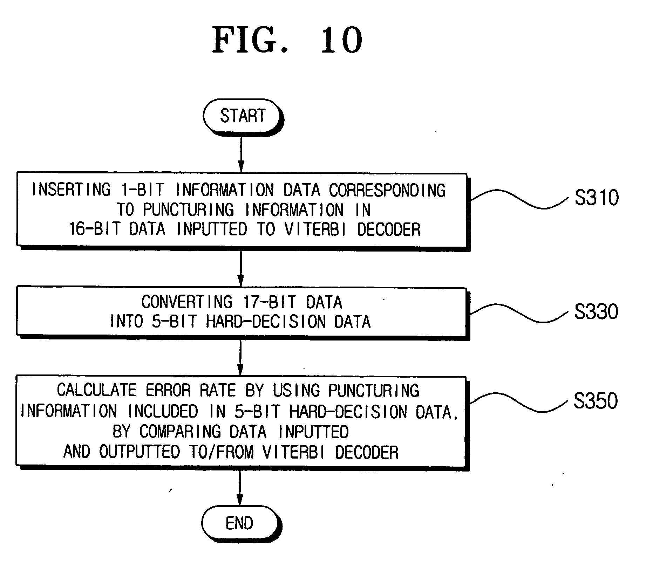

FIG. 9 is a schematic block diagram of the performance measuring apparatus 700 of the channel decoding apparatus according to the third example, and FIG. 10 is a flowchart illustrating a performance measuring method of the performance measuring apparatus 700 of FIG. 9.

The third example will be described in greater detail below with reference to FIGS. 9 and 10.

The performance measuring apparatus 700 includes a puncturing vector inserting unit 710, a hard-decision unit 720, a delay unit 730, a re-encoder 740, an error calculating unit 750 and an error display unit 760.

The puncturing vector inserting unit 710 inserts puncturing vector information in the depunctured data.

As described earlier, in the general European DAB system, the puncturing vectors usually fall into four types, i.e., 1111, 1110, 1100, 1000 with respect to the hard-decision, with each bits being 4-bit soft-decision data. '1' denotes no-puncturing, and '0' denotes puncturing. Left end is the most significant bit (MSB) and thus input starts from the left end. As shown in the puncturing vectors, MSB is always set to '1' and all the bits after 0bit are always set to '0'. The puncturing vector information can be estimated by using 2-bit data which corresponds to the number of zeros "0" of the puncturing vector. Estimating of the puncturing vector will be described in greater detail below. The puncturing vector inserting unit 710 adds 1 bit to the depunctured data, thereby outputting the data in which 17bit puncturing vector information is inserted. 17-bit data output from the puncturing vector inserting unit 710 is as follows:
1. With the puncturing vector '1111', output data consist '0, 4D, 4D, 4D, 4D'
2. With the puncturing vector '1110', output data consist '1, 0, 4D, 4D, 4D'
3. With the puncturing vector '1100', output data consist '1, 8, 7, 4D, 4D'
4. With the puncturing vector '1000', output data consist '1, 8, 8, 7, 4D'.
(where, '4D' denotes 4-bit data, '7' denotes a predetermined depunctured data, and '8' denotes apredetermined data for making 2-bit information about number of '1' bits of the puncturing vectors).

The hard-decision unit 720 converts the 17-bit data from the puncturing vector inserting unit 710 into hard-decision data (step S330). Conversion of soft-decision data into hard-decision data involves the process in which the data represented by '0' to '15' are converted to be represented by '0' or '1'. For example, 14 soft-decision data is converted into '1' hard-decision data, and 2 soft-decision data is converted into '0' hard-decision data.

After the conversion, 5-bit data are outputted from the hard-decision unit 720 in the respective data structure as follows.
1. 5-bit data of '0, D, D, D, D' are outputted from the 17-bit data of '0, 4D, 4D, 4D, 4D'
2. 5-bit data of '1, 0, D, D, D' are outputted from the 17-bit data of '1, 0, 4D, 4D, 4D'
3. 5-bit data of '1, 1, 0, D, D' are outputted from the 17-bit data of '1, 8, 7, 4D, 4D'
4. 5-bit data of '1, 1, 1, 0, D' are outputted from the 17-bit data of '1, 8, 8, 7, 4D'.

The delay unit 730 delays the 5-bit hard-decision data for the duration as much as the process time of the viterbi decoder 600, and then outputs the delayed data.

The re-encoder 740, being constructed with the same circuit as the convolution encoder of the transmitting end, performs convolution encoding with respect to the data which were decoded at the viterbi decoder 600. Accordingly, the re-encoder 740 encodes a single data into plural data.

Using the puncturing information included in the hard-decision data that are delayed for the duration as much as the processing time of the viterbi decoder 600 and then outputted from the delay unit 730, the error calculating unit 750 compares the data from the re-encoder 740 with only the non-punctured bits of the hard-decision data (step S350). Puncturing vectors are extracted from the 5-bit hard-decision data respectively as follows:
1. In the case of 5-bit hard-decision data with a '0' MSB, the puncturing vector is '1111'
2. In the case of 5-bit hard-decision data with a '1' MSB and '0' bit next to the MSB, the puncturing vector is '1110'
3. In the case of 5-bit hard-decision data with a '1' MSB and '10' 2-bits next to the MSB, the puncturing vector is '1100'
4. In the case of 5-bit hard-decision data with a '1' MSB and '11' 2-bits next to the MSB, the puncturing vector is '1000'.

In other words, the error calculating unit 750 calculates an error rate of the viterbi decoder 600 based on the puncturing vectors that are estimated from the data from the delay unit 730 and from the re-encoder 740.

The error display unit 760 externally displays the error rate calculated by the error calculating unit 750.

Because the puncturing information is inserted in the depunctured data, the performance measuring apparatus 700 of the viterbi decoder 600 requires no puncturing unit (74; FIG. 4) and thus, it can be constructed in a simple design.

According to the first aspect of the present invention, the deinterleaver memory of improved address structure stores data in a linear manner, and utilizes empty memory spaces efficiently.

According to the second aspect of the present invention, ENABLE signal is applied to the viterbi decoder based on the puncturing information and decoding time of the viterbi decoder is shortened. As a result, decoding time of the entire channel decoding apparatus of the DAB receiver is shortened, and power consumption is subsequently reduced.

According to the third aspect of the present invention, 1-bit puncturing information is inserted in the depunctured data by the performance measuring apparatus of the viterbi decoder. As a result, transmission signal size is reduced, and circuit design is simplified. In other words, simple circuit and less power consumption can be obtained.

The features of the present invention as described above, especially the reduced power consumption can be quite effective, considering the fact that the European digital audio broadcasting (DAB) system is used in the mobile communication applications.

Although a few preferred embodiments of the present invention has been described, it will be understood by those skilled in the art that the present invention should not be limited to the described preferred embodiments, but various changes and modifications can be made within the present invention as defined by the appended claims.

## Claims

1. A channel decoding apparatus of a European digital audio broadcasting, DAB, receiver, comprising:
a deinterleaver memory (200) having an address which comprises a combination of a first address that designates one data group among plural data groups and a second address that designates one data among data included in the respective data groups, wherein the deinterleaver memory has an address structure having the second address as an upper address and the first address as a lower address of the combination of the first and the second address; wherein the plural data groups are common interleaved frames;
a mapper (100) for mapping and storing an input data in the deinterleaver memory according to the address structure of the deinterleaver memory;
a deinterleaver (300) for, at a regular timing, deinterleaving the data stored in the deinterleaver memory and thereby generating a deinterleaved data;
a depuncturing unit (400) for inserting into the deinterleaved data a predetermined value in the place of a punctured data based on a puncturing information, thereby generating a deinterleaved and depunctured data; and
a viterbi decoder (600) for decoding a predetermined unit of coded data into an original form of the coded data before coding, wherein the predetermined unit of code data being comprised of the deinterleaved and depunctured data.

2. The channel decoding apparatus of claim 1, wherein
the one data group among the plural data groups has a 4-bit address,
the one data among data included in the respective data groups has a 15-bit address, and
the address structure of the deinterleaver memory has the 15-bit address as the upper address and 4-bit address as the lower address.

3. A channel decoding method of a European digital audio broadcasting, DAB, receiver, comprising the steps of:
storing data according to an address structure of a deinterleaver memory (200) having an address which comprises a combination of a first address designating one data group among plural data groups and a second address designating one data among data included in the respective data groups, wherein the address structure having the second address as an upper address and the first address as a lower address of the combination of the first and the second address; wherein the plural data groups are common interleaved frames;
deinterleaving at a regular timing the data which are stored according to the address structure and thereby generating a deinterleaved data;
inserting into the deinterleaved data a predetermined value in the place of a punctured data based on a puncturing information, thereby generating a deinterleaved and depunctured data; and
decoding a predetermined unit of coded data into an original form of the coded data before coding, wherein the predetermined unit of code data being comprised of the deinterleaved and depunctured data.

4. The channel decoding method of claim 3, wherein, in the storing step:
the one data group among the plural data groups has a 4-bit address,
the one data among data included in the respective data groups has a 15-bit address, and
the storing step stores the data according to the address structure that has the 15-bit address as the upper address and 4-bit address as the lower address.

## Patentansprüche

1. Kanaldecodiervorrichtung eines europäischen DAB-Empfängers (Digital Audio Broadcasting DAB, digitaler Audiorundfunk), umfassend:
einen Entschachtlerspeicher (200) mit einer Adresse, die eine Kombination aus einer ersten Adresse zur Bezeichnung einer Datengruppe unter mehreren Datengruppen und einer zweiten Adresse zur Bezeichnung eines Datenelements unter in den jeweiligen Datengruppen enthaltenen Daten umfasst, wobei der Entschachtlerspeicher eine Adressstruktur aufweist, bei der die zweite Adresse eine obere Adresse und die erste Adresse eine untere Adresse der Kombination aus der ersten und der zweiten Adresse ist; wobei die mehreren Datengruppen gemeinsame verschachtelte Frames bzw. Rahmen sind;
einen Abbilder (100) zum Abbilden und Speichern von Eingabedaten in dem Entschachtlerspeicher entsprechend der Adressstruktur des Entschachtlerspeichers;
einen Entschachtler (300) zum mit einer regelmäßigen Zeiteinstellung erfolgenden Entschachteln der in dem Entschachtlerspeicher gespeicherten Daten und hierdurch erfolgenden Erzeugen eines entschachtelten Datums;
eine Depunktiereinheit (400) zum in die entschachtelten Daten hinein erfolgenden Einfügen eines vorbestimmten Wertes an der Stelle von punktierten Daten auf Grundlage einer Punktierinformation zum hierdurch erfolgenden Erzeugen von entschachtelten und depunktierten Daten; und
einen Viterbi-Decoder (600) zum Decodieren einer vorbestimmten Einheit von codierten Daten in eine Ursprungsform der codierten Daten vor dem Codieren, wobei die vorbestimmte Einheit von Codedaten aus den entschachtelten und depunktierten Daten zusammengesetzt ist.

2. Kanaldecodiervorrichtung nach Anspruch 1, wobei
die eine Datengruppe unter den mehreren Datengruppen eine 4-Bit-Adresse aufweist,
das eine Datenelement unter den in den jeweiligen Datengruppen enthaltenen Daten eine 15-Bit-Adresse aufweist und bei der Adressstruktur des Entschachtlerspeichers die 15-Bit-Adresse die obere Adresse und die 4-Bit-Adresse die untere Adresse ist.

3. Kanaldecodierverfahren eines europäischen DAB-Empfängers (Digital Audio Broadcasting DAB, digitaler Audiorundfunk), umfassend die nachfolgenden Schritte:
Speichern von Daten entsprechend einer Adressstruktur eines Entschachtlerspeichers (200) mit einer Adresse, die eine Kombination aus einer ersten Adresse zur Bezeichnung einer Datengruppe unter mehreren Datengruppen und einer zweiten Adresse zur Bezeichnung eines Datenelements unter in den jeweiligen Datengruppen enthaltenen Daten umfasst, wobei bei der Adressstruktur die zweite Adresse eine obere Adresse und die erste Adresse eine untere Adresse der Kombination aus der ersten und der zweiten Adresse ist; wobei die mehreren Datengruppen gemeinsame verschachtelte Frames bzw. Rahmen sind;
mir einer regelmäßigen Zeiteinstellung erfolgendes Entschachteln der Daten, die entsprechend der Adressstruktur gespeichert sind, und hierdurch erfolgendes Erzeugen von entschachtelten Daten;
in die entschachtelten Daten hinein erfolgendes Einfügen eines vorbestimmten Wertes an der Stelle von punktierten Daten auf Grundlage einer Punktierinformation zum hierdurch erfolgenden Erzeugen von entschachtelten und depunktierten Daten; und
Decodieren einer vorbestimmten Einheit von codierten Daten in eine Ursprungsform der codierten Daten vor dem Codieren, wobei die vorbestimmte Einheit von Codedaten aus den entschachtelten und depunktierten Daten zusammengesetzt ist.

4. Kanaldecodierverfahren nach Anspruch 3, wobei in dem Speicherschritt:
die eine Datengruppe unter den mehreren Datengruppen eine 4-Bit-Adresse aufweist,
das eine Datenelement unter in den jeweiligen Datengruppen enthaltenen Daten eine 15-Bit-Adresse aufweist und
der Speicherschritt die Daten entsprechend der Adressstruktur speichert, bei der die 15-Bit-Adresse die obere Adresse und die 4-Bit-Adresse die untere Adresse ist.

## Revendications

1. Appareil de décodage de canal d'un récepteur européen de diffusion audio numérique DAB, soit Digital Audio Broadcasting, comprenant :
une mémoire de désentrelaceur (200) ayant une adresse qui comprend une combinaison d'une première adresse désignant un groupe de données parmi une pluralité de groupes de données et une seconde adresse désignant une donnée parmi des données comprises dans les groupes de données respectifs, dans lequel la mémoire du désentrelaceur comporte une structure d'adressage ayant la seconde adresse comme adresse supérieure et la première adresse comme adresse inférieure de la combinaison des première et seconde adresses ; dans lequel la pluralité de groupes de données sont des trames entrelacées communes ;
un mappeur (100) pour mettre en correspondance et enregistrer des données d'entrée dans la mémoire du désentrelaceur selon la structure d'adressage de la mémoire du désentrelaceur ;
un désentrelaceur (300) pour effectuer, à intervalles réguliers, le désentrelacement des données enregistrées dans la mémoire du désentrelaceur et générer ainsi des données désentrelacées ;
une unité de dépoinçonnage (400) pour insérer une valeur prédéterminée dans les données désentrelacées afin de remplacer une donnée poinçonnée en fonction d'une information de poinçonnage, générant ainsi une donnée désentrelacée et dépoinçonnée ; et
un décodeur de Viterbi (600) pour décoder une unité prédéterminée de données encodées dans une forme originale des données encodées avant encodage, dans lequel l'unité prédéterminée de données encodées comprend des données désentrelacées et dépoinçonnées.

2. Appareil de décodage de canal selon la revendication 1, dans lequel
ledit groupe de données parmi la pluralité de groupes de données présente une adresse à 4 bits,
ladite donnée parmi les données incluses dans les groupes de données respectifs présente une adresse à 15 bits, et la structure d'adressage de la mémoire du désentrelaceur présente une adresse à 15 bits comme adresse supérieure et une adresse à 4 bits come adresse inférieure.

3. Procédé de décodage de canal d'un récepteur européen de diffusion audio numérique DAB, soit Digital Audio Broadcasting, comprenant les étapes consistant à :
enregistrer des données en fonction d'une structure d'adressage d'une mémoire du désentrelaceur (200) ayant une adresse qui comprend une combinaison d'une première adresse désignant un groupe de données parmi une pluralité de groupes de données et une seconde adresse désignant une donnée parmi des données comprises dans les groupes de données respectifs, dans lequel la structure d'adressage présente la seconde adresse comme adresse supérieure et la première adresse comme adresse inférieure de la combinaison des première et seconde adresses ; dans lequel la pluralité de groupes de données sont des trames entrelacées communes ;
le désentrelacement, à intervalles réguliers, des données enregistrées en fonction de la structure d'adressage et ainsi la génération de données désentrelacées ;
l'insertion d'une valeur prédéterminée dans les données désentrelacées afin de remplacer une donnée poinçonnée en fonction d'une information de poinçonnage, générant ainsi une donnée désentrelacée et dépoinçonnée ; et
le décodage d'une unité prédéterminée de données encodées dans une forme originale des données encodées avant encodage, dans lequel l'unité prédéterminée de données encodées comprend des données désentrelacées et dépoinçonnées.

4. Procédé de décodage de canal selon la revendication 3, dans lequel, lors de l'étape d'enregistrement :
ledit groupe de données parmi la pluralité de groupes de données présente une adresse à 4 bits,
ladite donnée parmi les données incluses dans les groupes de données respectifs présente une adresse à 15 bits, et
l'étape d'enregistrement enregistre les données en fonction de la structure d'adressage, qui présente une adresse à 15 bits comme adresse supérieure et une adresse à 4 bits come adresse inférieure.
